(19) Europäisches Patentamt
European Patent Office
Office européen des brevets

(11) **EP 4 230 966 A1**

(12) **EUROPÄISCHE PATENTANMELDUNG**

(43) Veröffentlichungstag:
**23.08.2023  Patentblatt 2023/34**

(21) Anmeldenummer: **22156980.9**

(22) Anmeldetag: **16.02.2022**

(51) Internationale Patentklassifikation (IPC):
*G01D 4/00* (2006.01)   *G06Q 50/06* (2012.01)
*H02J 13/00* (2006.01)   *G06Q 30/00* (2023.01)
*H02J 1/00* (2006.01)   *G01K 17/06* (2006.01)

(52) Gemeinsame Patentklassifikation (CPC):
**G01D 4/00; G01K 17/06; G06Q 30/0283;
G06Q 30/04; G06Q 50/06; H02J 13/00;**
G01D 2204/22; G01D 2204/47

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft
80333 München (DE)**

(72) Erfinder:
• **Niessen, Stefan
91056 Erlangen (DE)**
• **Thiem, Sebastian
91413 Neustadt an der Aisch (DE)**

(74) Vertreter: **Siemens Patent Attorneys
Postfach 22 16 34
80506 München (DE)**

(54) **ENERGIESYSTEM MIT UNVOLLSTÄNDIGEN MESSDATEN**

(57)    Die Erfindung betrifft ein Verfahren zum Auswerten von Messwerten eines Energiesystems, wobei das Energiesystem Komponenten (COMPONENT) umfasst, welche durch Energieflüsse (FLOW) miteinander verbunden sind. Nur für eine Teilmenge der Energieflüsse (FLOW) liegen Messwerte vor. Es erfolgt eine Berechnung von Werten für zumindest manche Energieflüsse (FLOW), für welche keine Messwerte vorliegen, indem nacheinander verschiedene Untersysteme (SUBSYS) des Energiesystems betrachtet werden, und in jedem Untersystem (SUBSYS) wird eine Berechnung eines Werts für einen oder mehrere Energieflüsse (FLOW) vorgenommen.

FIG 1

EP 4 230 966 A1

**Beschreibung**

Die Erfindung betrifft ein Verfahren zum Auswerten von Messwerten eines Energiesystems.

Ein Energiesystem umfasst Komponenten, zwischen denen verschiedene Energiearten transportiert werden. Hierbei kann es sich z.B. um elektrische, thermische, fossile Energie handeln, oder auch um Energie, welche durch andere Stoffströme transportiert wird. Wenn Messeinrichtungen für alle Energieflüsse zwischen allen Komponenten des Energiesystems vorhanden wären, läge ein vollständiger Energiedatensatz vor. Dies ist vorteilhaft für das Betreiben des Energiesystems, insbesondere für den wirtschaftlichen und somit auch umweltschonenden Umgang mit Ressourcen.

In der Regel wird in einem Energiesystem jedoch nicht für jeden Energiefluss ein eigener Zähler installiert. Die Gründe hierfür können vielfältig sein, z.B. spielen Installations- und Wartungsaufwand, sowie Platzmangel eine Rolle. Dies bedeutet, dass Messwerte nur für eine Teilmenge der Energieflüsse verfügbar sind und somit ein unvollständiger Energiedatensatz vorliegt. Es wäre wünschenswert, auch für diejenigen Energieflüsse Messdaten zu erhalten, für welche keine Messgeräte zur Verfügung stehen.

Der Erfindung liegt die Aufgabe zugrunde, ein Verfahren zum Auswerten von Messwerten eines Energiesystems aufzuzeigen.

Diese Aufgabe wird durch ein Verfahren mit den Merkmalen des Anspruchs 1 gelöst. Ferner sind Gegenstand der Erfindung eine entsprechende Vorrichtung oder ein System zur Datenverarbeitung, ein entsprechendes Computerprogramm, ein entsprechender computerlesbarer Datenträger, und ein entsprechendes Datenträgersignal. Vorteilhafte Ausgestaltungen und Weiterbildungen sind Gegenstand von Unteransprüchen.

Das erfindungsgemäße Verfahren betrifft das Auswerten von Messwerten eines Energiesystems. Hierbei umfasst das Energiesystem Komponenten, welche durch Energieflüsse miteinander verbunden sind. Es liegen Messwerte für eine Teilmenge der Energieflüsse vor. Es erfolgt eine Berechnung von Werten für zumindest manche Energieflüsse, für welche keine Messwerte vorliegen. Hierzu werden nacheinander verschiedene Untersysteme des Energiesystems betrachtet, und in jedem Untersystem erfolgt eine Berechnung eines Werts für einen oder mehrere Energieflüsse.

Die Energieflüsse können gleiche oder verschiedene Energiearten transportieren. Beispiele für Energieflüsse sind: elektrischer Strom, ein Strom von Wasserdampf, ein Strom von kaltem/warmem Wasser, oder andersartige Stoffströme wie z.B. Wasserstoff, Erdgas oder andere Flüssigkeiten oder Gase. Im Fall von Stoffströmen kann als Einheit für die Energieflüsse diejenige eines Stoffflusses verwendet werden. Die Komponenten des Energiesystems haben zumindest einen Eingang und/oder einen Ausgang für einen oder mehrere Energieflüsse.

Die Energieflüsse können durch geeignete Zähler gemessen werden, so dass Messwerte für die mit Zählern versehenen Energieflüsse vorliegen. Das Energiesystem ist nicht vollständig mit Zählern ausgestattet oder nicht alle Zähler sind in Betrieb, so dass nur für manche Energieflüsse Messwerte verfügbar sind. Für manche oder alle Energieflüsse, für welche keine Messwerte vorhanden sind, wird ein Verfahren vorgeschlagen, mit welchem Werte ermittelt werden können.

Hierzu erfolgt eine gedankliche Unterteilung des Energiesystems in Untersysteme. Ein Untersystem umfasst hierbei eine oder mehrere Komponenten einschließlich der sie verbindenden Energieflüsse, sowie optional in das Untersystem hinaus- und/oder hineingehende Energieflüsse. Für ein solches Untersystem wird unter Verwendung der zu diesem Untersystem gehörenden Messwerte ein Wert für eine oder mehrere Energieflüsse berechnet, für welche keine Messwerte vorliegen. Dies erfolgt mehrfach nacheinander, wobei jeweils ein anderes Untersystem betrachtet wird. Diese Untersysteme können hierbei Überschneidungen aufweisen. Wurden bereits einer oder mehrere Werte für Energieflüsse berechnet, so können diese der Berechnung von Werten in einem anderen Untersystem zugrunde gelegt werden.

Vorteilhafterweise wird vor der Berechnung von Werten für zumindest manche Energieflüsse, für welche keine Messwerte vorliegen, die Topologie des Energiesystems als gerichteter Graph gespeichert. Diese Topologie umfasst zumindest die Komponenten und die sie miteinander verbindenden Energieflüsse, sowie gegebenenfalls weitere Energieflüsse, die in das Energiesystem hinein- oder aus ihm herausgehen. Zu dieser Topologie können auch die Messwerte und die berechneten Werte von Energieflüssen gespeichert werden. Dies kann mit fortschreitender Berechnung von Werten für Energieflüsse fortgeschrieben werden, so dass sich nach und nach ein teils oder komplett vervollständigtes Bild des Energiesystems ergibt.

In Weiterbildung der Erfindung wird für die Untersysteme jeweils ein Gleichungssystem aufgestellt mit Variablen in Form der zu berechnenden Werte für Energieflüsse des Untersystems, für welche keine Messwerte vorliegen. Als bekannte Größen können die Messwerte in die Gleichungssysteme eingesetzt werden. Vorteilhafterweise kann ein solches Gleichungssystem zumindest eine Modellgleichung einer Komponente des jeweiligen Untersystems umfassen, mit zumindest einem eine Effizienz der Komponente beschreibenden Parameter. Derartige Parameter sind wie auch die Messwerte bekannte Größen im Gleichungssystem. Außer den Modellgleichungen umfasst ein Gleichungssystem vorteilhafterweise ferner Energie- und/oder Massenbilanzgleichungen.

In Ausgestaltung der Erfindung werden Untersysteme ermittelt, für welche lösbare Gleichungssysteme aufstellbar sind. Abhängig davon, für welche Energieflüsse Messwerte vorliegen, kann das Gleichungssystem lösbar, unter- oder überbestimmt sein. Bei dem Verfahren wird gezielt nach Untersystemen gesucht, für welche die Anzahl der zu ermittelnden Werte gleich der Anzahl der Gleichungen und somit das Gleichungssystem lösbar ist.

Für ein Untersystem mit einem überbestimmten Gleichungssystem wird vorzugsweise zumindest ein fehlerhafter Messwert identifiziert. Hierbei kann die Erkenntnis ausgenutzt werden, dass der zumindest eine fehlerhafte Messwert in mehreren überbestimmten Gleichungssystemen enthalten ist. Das Auftauchen dieses Messwertes in mehreren unlösbaren Gleichungssystemen kann somit als Indiz dafür angesehen werden, dass etwas mit diesem Messwert nicht stimmt. Wurde ein solcher Messwert identifiziert, kann eine Fehlermeldung in Bezug auf diesen Messwert ausgegeben werden. Ferner kann der jeweilige Messwert in einem Gleichungssystem als unbekannt angesehen werden, so dass eventuell ein lösbares Gleichungssystem resultiert.

Für ein Untersystem mit einem unterbestimmten Gleichungssystem für zumindest einen Energiefluss, für welchen kein Messwert vorliegt, ist es vorteilhaft, einen fiktiven Messwert in das Gleichungssystem einzusetzen. Es wird hierdurch also fingiert, dass ein Messwert vorhanden ist, so dass eventuell ein lösbares Gleichungssystem resultiert.

Das erfindungsgemäße Verfahren und/oder eine oder mehrere Funktionen, Merkmale und/oder Schritte des erfindungsgemäßen Verfahrens und/oder einer seiner Ausgestaltungen können computergestützt ablaufen. Hierzu kommt eines oder mehrere miteinander zusammenwirkende Computerprogramme zum Einsatz. Werden mehrere Programme verwendet, so können diese gemeinsam auf einem Computer gespeichert und von diesem ausgeführt werden, oder auch auf verschiedenen Computern an verschiedenen Orten. Da dies funktional gleichbedeutend ist, wird vorliegend im Singular "das Computergrogramm" und "der Computer" formuliert.

Im Folgenden wird die Erfindung anhand eines Ausführungsbeispiels näher erläutert. Dabei zeigen:

Figur 1: ein Energiesystem,
Figur 2: einen Teil eines Energiesystems.

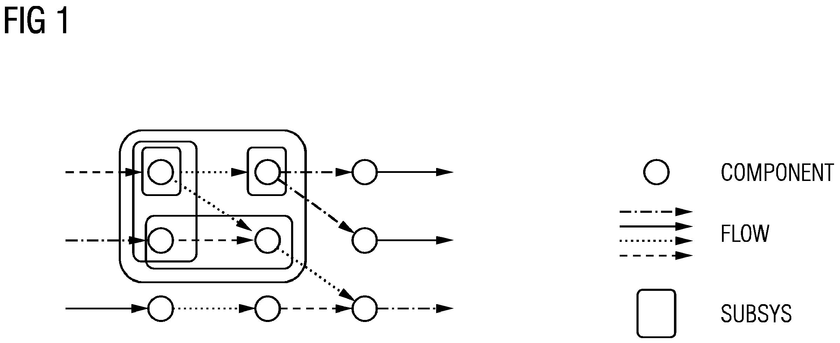

Im Folgenden wird ein Energiesystem betrachtet, welches schematisch in Figur 1 dargestellt ist. Hierbei kann es sich um das Energiesystem eines bestimmten Standorts, z.B. einer Wohnanlage oder eines Campus, handeln, oder auch um ein größeres, standortübergreifendes System.

Das Energiesystem besteht aus mehreren Komponenten COMPONENT. Hierbei handelt es sich um technische Geräte oder Anlagen, welche einen Eingang für eine Energieart und einen Ausgang für die gleiche oder eine andere Energieart haben, in letzterem Fall also verschiedene Energiearten ineinander umwandeln. Verschiedene Arten von Energien können hierbei die elektrische Energie, die fossile Energie, die Wärmeenergie sein; sie werden transportiert durch elektrischen Strom, Dampf- oder Stoffströme, wobei die Stoffströme z.B. Wasserstoff oder Erdgas transportieren können. Beispiele für Komponenten COMPONENT sind Kraft-Wärme-Kopplung basierte Kraftwerke, elektrische oder andere Energiespeicher wie Aggregate für Druckluft, Wärmepumpen, Kompressoren, Elektroauto-Ladestationen, ....

In Figur 1 sind die Komponenten COMPONENT verbunden durch verschiedene Energieflüsse FLOW. Diese Verbindung zwischen den Komponenten COMPONENT entspricht der inneren Struktur oder Topologie des Energiesystems. D.h. die Topologie des Energiesystems gibt an, welche Komponente COMPONENT mit welcher oder welchen anderen Komponente(n) COMPONENT über welche Art von Energiefluss FLOW verbunden ist.

Die in der Figur von links in das Energiesystem eingehenden Pfeile zeigen an, dass das Energiesystem z.B. an ein Strom- und Gasnetz angeschlossen ist, woher es mit Energie versorgt wird. Ferner kann auch eine Anbindung an ein anderes Energiesystem vorhanden sein. Die in der Figur nach rechts aus dem Energiesystem herausgehenden Pfeile zeigen an, dass an das Energiesystem verschiedene Verbraucher angeschlossen sein können. Ferner kann auch hier eine Anbindung an ein anderes Energiesystem vorhanden sein.

Idealerweise könnte für jeden Energiefluss FLOW eine Messeinrichtung vorhanden sein, so dass durch die Messdaten Werte für jeden Energiefluss FLOW vorliegen. Dies ist in realen Systemen üblicherweise nicht der Fall. Denn einerseits ist die Anschaffung, Installation und Wartung der Zähler teuer, andererseits ist auch der Umgang mit den Messdaten, d.h. die Übertragung und Speicherung dieser Werte, aufwendig. Es wird daher davon ausgegangen, dass für das Energiesystem zwar die Topologie bekannt ist, jedoch kein vollständiger Energiedatensatz vorliegt. Unter dem Energiedatensatz werden hierbei Werte für die die verschiedenen Komponenten COMPONENT des Energiesystems verbindenden Energieflüsse FLOW verstanden.

Das Ziel der im Folgenden beschriebenen Vorgehensweise ist es, den unvollständigen Energiedatensatz rechnerisch vollständig oder teilweise zu ergänzen oder zu vervollständigen. Es sollen also virtuelle Messdaten erzeugt werden, und zwar basierend auf der bekannten Topologie und dem unvollständigen Energiedatensatz. Dies erfolgt mittels eines systematischen Ansatzes, der es ermöglicht, Lücken im Energiedatensatz zu füllen. Die Berechnung der virtuellen Messdaten erfolgt hierbei automatisch durch ein Computerprogramm.

Hierzu wird zunächst die Topologie des Energiesystems als gerichteter Graph gespeichert. Außerdem werden die Verbindungen zwischen den Komponenten COMPONENT des Energiesystems, für welche Messdaten für den jeweiligen Energiefluss FLOW vorhanden sind, mit diesen Werten belegt. Für diese Speicherung der Topologie des Energiesystems in Kombination mit dem Energiedatensatzes sollte so granular wie möglich vorgegangen werden. D.h. die kleinstmöglichen Komponenten COMPONENT und die dazu gehörigen Energieflüsse FLOW sollten verwendet werden. Zur Reduzierung der Komplexität ist es jedoch auch möglich, mehrere Einzelkomponenten zu einer größeren Komponente COMPONENT zusammenzufassen. In diesem Fall müssen die innerhalb der größeren Komponente COMPONENT stattfindenden Energieflüsse nicht betrachtet und gespeichert werden, sondern nur die Energieflüsse FLOW, die in die größere Komponente COMPONENT hinein und aus ihr heraus gehen. Ein Beispiel für eine solche größere Komponente COMPONENT wäre ein Chemiewerk, welches als kleinere Komponenten mehrere chemische Reaktoren umfasst.

Als Einführung in die Vorgehensweise wird ein einfaches Beispiel betrachtet:

Es liegen Messwerte für den Energiefluss FLOW zu einer Gruppe von drei Komponenten COMPONENT vor, sowie für den Energieverbrauch zweier dieser Komponenten COMPONENT. Hieraus kann direkt der Energieverbrauch der dritten Komponente COMPONENT berechnet werden. Würde der Messwert sich hingegen auf einen Energiefluss FLOW zu einer Gruppe von vier Komponenten COMPONENT beziehen, wäre der Energieverbrauch der dritten und vierten Komponente COMPONENT nicht berechenbar. Es müsste ein weiterer Messwert beschafft werden, um ein Gleichungssystem aufstellen zu können, welches weder unter- noch überbestimmt ist.

Ein zentraler Aspekt ist es dementsprechend, innerhalb des gesamten Energiesystems Untersysteme zu finden, innerhalb welcher sich virtuelle Messdaten berechnen lassen, indem aufgrund der bekannten Topologie ein Gleichungssystem aufgestellt werden kann, das genauso viele Gleichungen wie zu bestimmende virtuelle Messdaten aufweist. Im Energiesystem der Figur 1 sind beispielhaft einige solcher Untersysteme SUBSYS gezeigt.

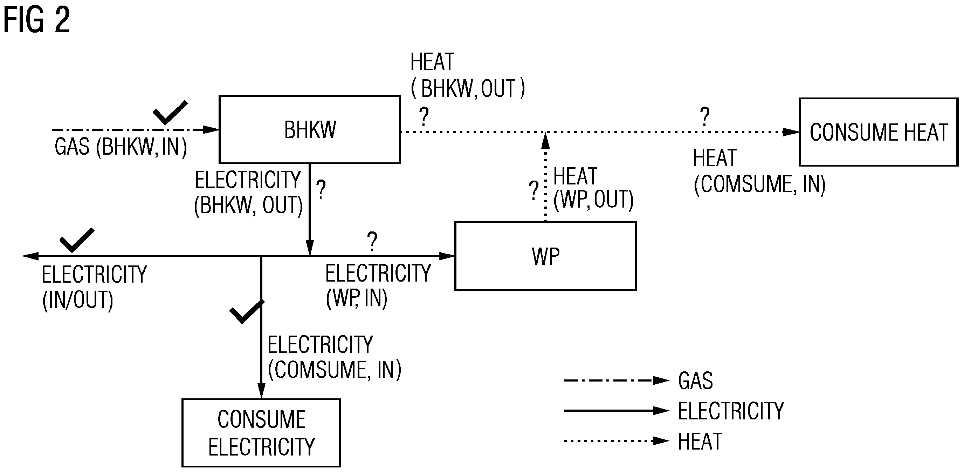

Im Folgenden wird anhand von Figur 2 ein konkretes Beispiel erläutert. Dieses entspricht nicht einem Teil der Figur 1, welche zum abstrakteren Verständnis der Erfindung verwendet wird. Das in Figur 2 abgebildete Untersystem SUBSYS umfasst als Komponenten COMPONENT ein Blockheizkraftwerk BHKW, eine Wärmepumpe WP, einen Wärmeverbraucher COMSUME HEAT, und einen Stromverbraucher CONSUME ELECTRICITY. Die unterschiedlichen Energieflüsse FLOW sind durch verschiedene Stricharten kenntlich gemacht: der Energiefluss FLOW des Gases durch einen Pfeil mit strichlierter Linie, der Energiefluss FLOW des elektrischen Stromes durch einen Pfeil mit durchgezogener Linie, und der Energiefluss FLOW der Wärme durch einen Pfeil mit gepunkteter Linie.

Die Topologie des in Figur 2 abgebildeten Untersystems SUBSYS ist folgendermaßen:

In das Blockheizkraftwerk BHKW geht der Gas-Energiefluss GAS(BHKW,IN) ein. Er kommt von einer Komponente des Energiesystems, die nicht Teil des Untersystem SUBSYS der Figur 2 ist. Messdaten für diesen Energiefluss GAS(BHKW,IN) liegen vor - kenntlich gemacht durch einen Haken an dem zugehörigen Pfeil - , sie stammen von einem in der Figur nicht dargestellten Gaszähler.

Aus dem Blockheizkraftwerk BHKW kommt der Wärme-Energiefluss HEAT(BHKW,OUT). Für den Wärme-Energiefluss HEAT(BHKW,OUT) gibt es keinen Zähler, kenntlich gemacht durch ein Fragezeichen an dem zugehörigen Pfeil.

Ferner kommt aus dem Blockheizkraftwerk BHKW der Strom-Energiefluss ELECTRICITY(BHKW,OUT). Für den Strom-Energiefluss ELECTRICITY(BHKW,OUT) gibt es keinen Zähler, kenntlich gemacht durch ein Fragezeichen an dem zugehörigen Pfeil.

In die Wärmepumpe WP geht der Strom-Energiefluss ELECTRICITY (WP,IN) ein. Für den Strom-Energiefluss ELECTRICITY (WP,IN) gibt es keinen Zähler, kenntlich gemacht durch ein Fragezeichen an dem zugehörigen Pfeil.

Aus der Wärmepumpe WP kommt der Wärme-Energiefluss HEAT(WP,OUT). Für den Wärme-Energiefluss HEAT(WP,OUT) gibt es keinen Zähler, kenntlich gemacht durch ein Fragezeichen an dem zugehörigen Pfeil.

In den Wärmeverbraucher COMSUME HEAT geht der Wärme-Energiefluss HEAT(CONSUME,IN). Für den Wärme-Energiefluss HEAT(CONSUME,IN) gibt es keinen Zähler, kenntlich gemacht durch ein Fragezeichen an dem zugehörigen Pfeil.

In den Stromverbraucher CONSUME ELECTRICITY geht der Strom-Energiefluss ELECTRICITY(CONSUME,IN). Messdaten für diesen Energiefluss ELECTRICITY(CONSUME,IN) liegen vor - kenntlich gemacht durch einen Haken an dem zugehörigen Pfeil - , sie stammen von einem in der Figur nicht dargestellten Stromzähler.

Auf der linken Seite befindet sich ferner der Strom-Energiefluss ELECTRICITY(IN/OUT), welcher mit dem Blockheizkraftwerk BHKW, der Wärmepumpe WP und dem Stromverbraucher CONSUME ELECTRICITY verbunden ist. Der Strom-Energiefluss ELECTRICITY(IN/OUT) kann hierbei sowohl in das Untersystem SUBSYS der Figur 2 eingehen, als auch herausgehen. Messdaten für diesen Energiefluss ELECTRICITY(IN/OUT) liegen vor - kenntlich gemacht durch einen Haken an dem zugehörigen Pfeil - , sie stammen von einem in der Figur nicht dargestellten Stromzähler.

Die Topologie des Untersystems SUBSYS kann durch Gleichungen beschrieben werden. Hierbei handelt es sich einerseits um Energiebilanzgleichungen, andererseits um Modellgleichungen von Komponenten COMPONENT.

Die Energiebilanzgleichungen beruhen auf dem Energieerhaltungssatz. Demnach muss für jedes beliebige Untersystems SUBSYS die hineingehenden und die herauskommenden Energieflüsse FLOW in Summe gleich groß sein. Für das in Figur 2 betrachtete Untersystem SUBSYS gilt:

$$(1) \quad \mathrm{HEAT(BHKW,OUT)+HEAT(WP,OUT)=HEAT(CONSUME,IN)}$$

$$(2) \quad ELECTRICITY(IN/OUT)= ELECTRICITY(BHKW,OUT)- ELECTRICITY(WP,IN)- ELECTRICITY(CONSUME,IN)$$

Die Modellgleichungen beschreiben die Effizienz der Arbeitsweise von bestimmte Energieformen bereitstellenden Komponenten:

$$(3) \quad ELECTRICITY(BHKW,OUT)=GAS(BHKW,IN)* Wirkungsgrad(BHKW, ELECTRICITY)$$

$$(4) \quad HEAT(BHKW,OUT)= GAS(BHKW,IN)* Wirkungsgrad(BHKW, HEAT)$$

$$(5) \quad HEAT(WP,OUT)= ELECTRICITY(WP,IN)* COP(WP)$$

Bei den Modellgleichungen werden die Effizienz beschreibende Parameter verwendet. Hierbei beschreibt der Parameter Wirkungsgrad(BHKW, ELECTRICITY) die Effizienz der Bereitstellung elektrischer Energie durch das Blockheizkraftwerk BHKW, er könnte beispielsweise 33% betragen. Der Parameter Wirkungsgrad(BHKW, HEAT) betrifft dementsprechend die Effizienz der Bereitstellung thermischer Energie durch das Blockheizkraftwerk BHKW, er könnte beispielsweise 55% betragen. Ferner steht der Parameter COP(WP) für den Coefficient of Performance der Wärmepumpe, er könnte beispielsweise 3,5 betragen. Letzterer hängt stark vom Prozess ab, der von der Wärmepumpe WP angewendet wird, insbesondere ob die Wärmepumpe dem Grundwasser oder der Umgebungsluft Wärme entzieht.

Mit den 2 Energiebilanzgleichungen und den 3 Modellgleichungen liegt somit ein Gleichungssystem aus 5 Gleichungen vor, mit den 5 unbekannten Energiedaten HEAT(BHKW,OUT), HEAT(WP,OUT), HEAT(CONSUME,IN), ELECTRICITY(BHKW,OUT), ELECTRICITY(WP,IN). Durch Lösen des Gleichungssystems können daher virtuelle Messdaten für diese 5 unbekannten Energiedaten berechnet werden. Somit liegt ein vollständiger Satz an Messdaten für das Untersystems SUBSYS der Figur 2 vor.

Als Einheit für die Werte der Energieflüsse FLOW wird kW oder MW verwendet. Bezogen auf die realen Messwerte handelt es sich um Energiepakete, welche innerhalb eines definierten Zeitraums übertragen werden. Hierzu ist für das Auslesen der Zähler eine geeignete Zeitbasis zu verwenden, so dass die Energiemengen betrachtet werden, die in einem passend gewählten Zeitraum übertragen werden, z.B. in einer oder wenigen Minuten. Es werden also nicht Leistungen betrachtet, da diese oft nicht genau zueinander passen; denn oft sind in Leitungen, z.B. in diversen Rohrleitungen, Trägheiten bzw. Kapazitäten vorhanden. Durch das "Sammeln" der Energiemenge über den definierten Zeitraum erfolgt eine zeitliche Mittelung, so dass der Effekt der Trägheit kaum eine Rolle spielt.

Für Komponenten, welche so viel Energie speichern, dass dies sich nicht innerhalb weniger Minuten herausmittelt, sollte anders vorgegangen werden: diese können explizit als Energiespeicher modelliert werden. Beispiele sind eine Batterie oder ein Warmwasserspeicher. Auch für Speicher ist die beschriebene Methode gut geeignet, denn es ist in der Praxis ein großes Problem, den Energieinhalt eines Speichers zu bestimmen. In die Gleichungssysteme wird dann neben den bereits erläuterten Energieflüssen zusätzlich noch der Speicherfüllstand als weitere Variable eingeführt.

Wie oben bereits erläutert, ist es ein wesentlicher Aspekt, im gesamten Energiesystem solche Untersysteme zu finden, in welchen sich sämtliche virtuelle Messdaten berechnen lassen. Dies wird dadurch ermöglicht, dass die Energiebilanzgleichungen und die Modellgleichungen für das gesamte System zusammen mit der Topologie gespeichert sind. Das Computerprogramm bildet und betrachtet daher so lange verschiedene Untersysteme, bis ein Untersystem aufgefunden wird, bei welchem die Berechnung sämtlicher virtueller Messdaten möglich ist. Figur 1 zeigt beispielhaft fünf verschiedene Untersysteme SUBSYS. Ein Untersystem SUBSYS besteht grundsätzlich aus einer oder mehreren Komponenten COMPONENT des Energiesystems, welche mit Energieflüssen FLOW miteinander verbunden sind. Während die in Figur 1 gezeigten Untersysteme Rechtecke sind, können diese auch hiervon abweichende Formen aufweisen.

Nach Berechnung der virtuellen Messdaten für ein Untersystem werden diese virtuellen Messdaten - ebenso wie die realen Messdaten - zusammen mit der Topologie gespeichert. Im Anschluss wird das nächste Untersysteme SUBSYS gesucht, in welchem sämtliche virtuelle Messdaten berechenbar sind. Hierbei werden die zuvor berechneten virtuellen Messdaten als bekannt vorausgesetzt. Auf diese Weise kann nach und nach der Energiedatensatz des Energiesystems so weit wie möglich vervollständigt werden.

Am einfachsten ist die Situation, wenn sich auf die oben erläuterte Weise der vollständige Energiedatensatz bestimmen lässt. Dies impliziert, dass nach und nach Gleichungssysteme gefunden werden, bei welchen die Anzahl der Unbekannten - also der zu berechnenden virtuellen Messdaten - mit der Anzahl der Gleichungen übereinstimmt. In Realität wird jedoch oftmals die Situation auftreten, dass nach einigen Berechnungen nur noch über- oder unterbestimmte Gleichungssysteme aufstellbar sind. D.h. der Energiedatensatz ist zwar noch nicht vollständig, es sind also noch nicht alle virtuellen Messdaten bestimmt, jedoch lässt sich kein geeignetes Untersystem SUBSYS mehr finden, welches eine direkte Berechnung von virtuellen Messdaten ermöglicht.

In dieser Situation kann es ausreichend sein, den Algorithmus zu beenden. Dies ist dann der Fall, wenn es nicht nötig ist, den vollständigen Energiedatensatz zur Hand zu haben. Es kann sein, dass eine Teilmenge an Messdaten des Energiedatensatzes ausreichend Informationen liefert. Durch das beschriebene Verfahren wurde diese Teilmenge maximiert, d.h. die Menge der unbekannten virtuellen Messdaten wurde minimiert.

Dass üblicherweise die geschilderte Situation auftreten wird, in welcher nur noch über- oder unterbestimmte Gleichungssysteme aufstellbar sind, ist auch der Grund dafür, dass nicht anstelle des beschriebenen iterativen Vorgehens der vollständige Energiedatensatz durch Lösen eines einzigen Gleichungssystems basierend auf dem vollständigen Energiesystem berechenbar ist. Dieses Gleichungssystem ist meist aufgrund von Unter- oder Überbestimmung nicht lösbar. Wie bereits erläutert, liefert die Zerlegung des Problems in Teilprobleme die größtmögliche Anzahl berechenbarer virtueller Messdaten.

Zum Fall der überbestimmten Gleichungssysteme:
Dies führt dazu, dass es mathematisch gesehen keine Lösung für die jeweiligen im Energiedatensatz fehlenden Daten gibt.

Der Grund hierfür liegt darin, dass unterschiedliche Zähler zueinander inkonsistente Werte liefern. Dies kann verschiedene Ursachen haben. Zum einen kann es sein, dass ein Zähler defekt ist und daher falsche Messergebnisse liefert, oder ganz ausfällt und den Messwert Null ausgibt. Zum anderen können eine fehlende Messgenauigkeit oder zeitliche Verzögerungen der Messwerte ursächlich sein.

In dieser Konstellation der überbestimmten Gleichungssysteme sind mehrere Vorgehensweisen möglich. Besonders geschickt ist es, einen Zähler zu identifizieren, dessen Werte in mehreren aufgrund von Überbestimmung unlösbaren Gleichungssystemen enthalten sind. Dies kann ein Indiz dafür sein, dass dieser Zähler fehlerhaft arbeitet. Seine Messwerte können daher auf unbekannt gesetzt werden, so dass zumindest manche der Gleichungssysteme lösbar werden. Letzterem Schritt kann eine Plausibilitätskontrolle dahingehend vorgelagert werden, ob die Messdaten des betroffenen Zählers sinnvolle Werte darstellen; nur wenn dies nicht der Fall ist, werden seine Messergebnisse ignoriert und der jeweilige Energiefluss als unbekannt angesehen. Die Messdaten des defekten Zählers werden nach Lösen des Gleichungssystems durch die für diesen Zähler berechneten virtuellen Messdaten ersetzt.

Zusätzlich oder alternativ zu dieser Veränderung von Messdaten ist es auch möglich, in einem überbestimmten Gleichungssystem nach denjenigen virtuellen Messdaten zu suchen, welche zum kleinsten Fehler innerhalb des Gleichungssystems führen, d.h. die bestmögliche Lösung darstellen. Hierfür können geeignete Optimierungsalgorithmen zum Einsatz kommen.

Des Weiteren lassen sich im Falle des überbestimmten Gleichungssystem für die fehlenden Werte mehrere unterschiedliche virtuelle Messdaten bestimmen. Der sich so ergebende Wertebereich ist eine gute Abschätzung der Messungenauigkeit für die Bestimmung des jeweils bestimmten Wertes.

Zum Fall der unterbestimmten Gleichungssysteme:
In dieser Konstellation ist es die einfachste Möglichkeit, für einen oder mehrere Zähler fiktive Messdaten zu verwenden.

Diese können z.B. typischen Messdaten gleichartiger anderer Zähler in einer ähnlichen Position innerhalb des Energiesystems entsprechen. Auch eine Mittelwertbildung von Messdaten anderer Zähler ist sinnvoll. Sollte es sich um einen Zähler handeln, welcher zuvor Messdaten lieferte und mittlerweile ausgefallen ist, können dessen veraltete Messdaten herangezogen werden.

Das beschriebene Verfahren kann automatisch von einem Computerprogramm ausgeführt werden. Als Eingaben benötigt das Programm hierzu die Topologie des Energiesystems, einschließlich der Gleichungen und Beziehungen, welche die innere Struktur des Netzwerks beschreiben, und die Messdaten. Hiervon ausgehend ermittelt das Computerprogramm möglichst viele virtuelle Messdaten. Eine weitere Ausgabegröße kann die Anzeige eines oder mehrerer als defekt erkannter Zähler sein, z.B. in Form einer Fehlermeldung.

In manchen Konstellationen mag es nicht von Interesse sein, den vollständigen Energiedatensatz an der Hand zu haben. Vielmehr könnte es sein, dass nur eine oder mehrere virtuelle Messdaten benötigt werden. Diese Vorgabe kann dem Computerprogramm gemacht werden, so dass dieses versucht, nur diese Größen zu berechnen.

Das Auffinden virtueller Messdaten wurde anhand von Energiebilanzgleichungen und Modellgleichungen beschrieben. Anstelle von Energiebilanzgleichungen können auch Massenbilanzgleichungen verwendet werden. Dies kann besonders vorteilhaft für hydraulische Systeme sein, also Wassernetze, Fernwärmenetze, etc. Analog zu den Energiebilanzgleichungen können hier die Massenbilanzgleichungen basierend auf der Massenerhaltung in diesen Systemen aufgestellt werden.

Zusätzlich oder alternativ zur Ermittlung der virtuellen Messdaten ist es möglich, alle oder manche der Parameter in den Gleichungen zu berechnen oder zu verifizieren. Hierzu werden diese Parameter in den jeweiligen Gleichungssystemen als unbekannte und somit zu berechnende Größen angesehen.

Das beschriebene Verfahren weist die folgenden Vorteile auf: Energieflüsse FLOW können auch für Teile des Energiesystems ermittelt werden, welche nicht mit Zählern ausgestattet sind. Dies ist kostensparend, da Zähler eingespart oder nicht eigens installiert werden müssen. Ferner können die virtuellen Daten aufgrund des hiermit zumindest teilweise vervollständigten Energiedatensatzes zum effizienteren Betreiben des Energiesystems beitragen.

Wenn sich herausstellt, dass bestimmte Messdaten oder eine Gruppe von Messdaten rechnerisch nicht ermittelbar sind, kann gezielt an dieser Position innerhalb des Energiesystems einer oder mehrere Zähler installiert werden.

Nach der Identifikation defekter Zähler aufgrund inkonsistenter Messdaten können diese instandgesetzt und mit korrekten Messdaten der reparierten Zähler das Energiesystem besser betrieben werden.

Da defekte Zähler erkannt werden, kann mit höherer Sicherheit davon ausgegangen werden, dass die anderen Zähler zuverlässig arbeiten. Dies kann bei der Planung von Wartungszyklen berücksichtigt werden.

Bereits durch Eingabe der Topologie mit den in Gleichungen enthaltenen Beziehungen zwischen den Komponenten und noch mehr durch die Anreicherung des Energiedatensatzes mit den virtuellen Messdaten liegt eine systematische Datenbasis für das gesamte Energiesystem vor. Dies kann für vielfältige Zwecke genutzt werden; konsistente, gute Daten sind die Grundlage für sehr vieles: z.B. Monitoring, Analytik, Betriebsoptimierung. Beispielsweise eignen sich die Daten für die Überprüfung, ob die Komponenten auch tatsächlich so miteinander gekoppelt wurden, wie dies laut Plan der Fall sein sollte. Auch lassen sich so bei elektrischen Systemen Kurzschlüsse, bei thermischen, hydraulischen oder pneumatischen Systemen Leckagen erkennen.

Die Erfindung wurde voranstehend an einem Ausführungsbeispiel beschrieben. Es versteht sich, dass zahlreiche Änderungen und Modifikationen möglich sind, ohne dass der Rahmen der Erfindung verlassen wird.

**Patentansprüche**

1. Verfahren zum Auswerten von Messwerten eines Energiesystems, wobei das Energiesystem Komponenten (COMPONENT) umfasst, welche durch Energieflüsse (FLOW) miteinander verbunden sind,

   bei dem
   Messwerte für eine Teilmenge der Energieflüsse (FLOW) vorliegen,
   eine Berechnung von Werten für zumindest manche Energieflüsse (FLOW) erfolgt, für welche keine Messwerte vorliegen, indem
   nacheinander verschiedene Untersysteme (SUBSYS) des Energiesystems betrachtet werden, und in jedem Untersystem (SUBSYS) eine Berechnung eines Werts für einen oder mehrere Energieflüsse (FLOW) erfolgt.

2. Verfahren nach Anspruch 1, bei dem
   vor der Berechnung die Topologie des Energiesystems als gerichteter Graph gespeichert wird.

3. Verfahren nach Anspruch 2, bei dem
   zur Topologie die Messwerte und die berechneten Werte für Energieflüsse (FLOW) gespeichert werden.

4. Verfahren nach einem der Ansprüche 1 bis 3, bei dem für die Untersysteme (SUBSYS) jeweils ein Gleichungssystem aufgestellt wird mit zu berechnenden Werten für Energieflüsse (FLOW) des Untersystems (SUBSYS), für welche keine Messwerte vorliegen, als Variablen.

5. Verfahren nach Anspruch 4, bei dem
   ein Gleichungssystem zumindest eine Modellgleichung einer Komponente (COMPONENT) des jeweiligen Untersystems (SUBSYS) umfasst, mit zumindest einem eine Effizienz der Komponente (COMPONENT) beschreibenden Parameter.

6. Verfahren nach Anspruch 4 oder 5, bei dem Untersysteme (SUBSYS) ermittelt werden, für welche lösbare Gleichungssysteme aufstellbar sind.

7. Verfahren nach einem der Ansprüche 4 bis 6, bei dem für ein Untersystem (SUBSYS) mit einem überbestimmten Gleichungssystem zumindest ein fehlerhafter Messwert identifiziert wird.

8. Verfahren nach Anspruch 7, bei dem
   das Identifizieren des zumindest einen fehlerhaften Messwertes erfolgt, indem der zumindest eine fehlerhafte Messwert als Bestandteil mehrerer überbestimmter Gleichungssysteme erkannt wird.

9. Verfahren nach einem der Ansprüche 4 bis 6, bei dem für ein Untersystem (SUBSYS) mit einem unterbestimmten Gleichungssystem für zumindest einen Energiefluss (FLOW), für welchen kein Messwert vorliegt, ein fiktiver Messwert in das Gleichungssystem eingesetzt wird.

10. Vorrichtung oder System zur Datenverarbeitung, umfassend Mittel zur Ausführung des Verfahrens nach einem der Ansprüche 1 bis 9.

11. Computerprogramm, umfassend Befehle, die bei der Ausführung des Programms durch einen Computer diesen veranlassen, die Schritte des Verfahrens nach einem der Ansprüche 1 bis 9 auszuführen.

12. Computerlesbarer Datenträger, auf dem das Computerprogramm nach Anspruch 11 gespeichert ist.

13. Datenträgersignal, das das Computerprogramm nach Anspruch 11 überträgt.

FIG 1

COMPONENT

FLOW

SUBSYS

# FIG 2

EP 4 230 966 A1

Europäisches
Patentamt

European
Patent Office

Office européen
des brevets

**EUROPÄISCHER RECHERCHENBERICHT**

**Nummer der Anmeldung**

**EP 22 15 6980**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2018/012157 A1 (KIKIRAS PANAYOTIS [DE] ET AL) 11. Januar 2018 (2018-01-11) * Abbildungen 1-5 * * Absätze [0052] – [0055] * * Absätze [0065] – [0069] * * Absatz [0128] * ----- | 1-13 | INV. G01D4/00 G06Q50/06 H02J13/00 G06Q30/00 H02J1/00 G01K17/06 |
| A | DE 10 2012 108536 A1 (DEUTSCHE TELEKOM AG [DE]; UNIV BERLIN TECH [DE]) 13. März 2014 (2014-03-13) * Abbildung 1 * * Anspruch 7 * ----- | 1-13 | |
| A | WO 2019/236061 A1 (BIDGELY INC [US]) 12. Dezember 2019 (2019-12-12) * Abbildung 1 * ----- | 1-13 | |
| A | US 2015/161020 A1 (MATSUOKA YOKY [US] ET AL) 11. Juni 2015 (2015-06-11) * Absätze [0078], [0079] * ----- | 1-13 | RECHERCHIERTE SACHGEBIETE (IPC) |
| A | US 10 585 123 B2 (NEC LAB AMERICA INC [US]; NEC CORP [JP]) 10. März 2020 (2020-03-10) * Abbildung 1 * ----- | 1-13 | G01D G06Q H02J G01W G01K |

Der vorliegende Recherchenbericht wurde für alle Patentansprüche erstellt

| Recherchenort | Abschlußdatum der Recherche | Prüfer |
|---|---|---|
| München | 29. Juli 2022 | Kuchenbecker, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

...............................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 22 15 6980

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-07-2022

| Im Recherchenbericht angeführtes Patentdokument | Datum der Veröffentlichung | Mitglied(er) der Patentfamilie | Datum der Veröffentlichung |
|---|---|---|---|
| US 2018012157 A1 | 11-01-2018 | US 2018012157 A1<br>WO 2018008031 A1 | 11-01-2018<br>11-01-2018 |
| DE 102012108536 A1 | 13-03-2014 | KEINE | |
| WO 2019236061 A1 | 12-12-2019 | KEINE | |
| US 2015161020 A1 | 11-06-2015 | KEINE | |
| US 10585123 B2 | 10-03-2020 | KEINE | |

EPO FORM P0461

Für nähere Einzelheiten zu diesem Anhang : siehe Amtsblatt des Europäischen Patentamts, Nr.12/82